# DEMANDE DE BREVET EUROPEEN

(11) **EP 4 757 540 A1**
(43) Date de publication de la demande: **10.06.2026**
(21) Numéro de dépôt: 25217999.9
(22) Date de dépôt: 24.11.2025
(51) Int. Cl.: H10F 19/90

(54) **MODULE PHOTOVOLTAÏQUE**

(30) Priorité: 05.12.2024 FR 2413506
(71) Demandeur: S'Tile, 86180 Buxerolles (FR)
(72) Inventeur: STRABONI, Alain, 86180 BUXEROLLES (FR); MALINGE, Antoine, 86180 BUXEROLLES (FR)
(74) Mandataire: Cabinet Beaumont

(57) **Abrégé**

La présente description concerne un module photovoltaïque (400) comprenant au moins un groupe (405) de chapelets de cellules photovoltaïques s'étendant selon un plan principal (XY), les cellules photovoltaïques d'un même chapelet étant électriquement reliées entre elles en série le long d'une première direction (X) du plan principal, chaque groupe comportant au moins :
- un premier chapelet (411) comprenant des premières cellules photovoltaïques (401) parmi les cellules photovoltaïques, les premières cellules photovoltaïques présentant chacune une première largeur (11) dans une deuxième direction (Y) du plan principal, perpendiculaire à la première direction ; et
- un deuxième chapelet (412) comprenant des deuxièmes cellules photovoltaïques (402) parmi les cellules photovoltaïques, les deuxièmes cellules photovoltaïques présentant chacune une deuxième largeur (12) dans la deuxième direction, la deuxième largeur étant inférieure à la première largeur.

## Description

### Domaine technique

La présente description concerne de façon générale le domaine des systèmes photovoltaïques, et vise plus particulièrement des modules photovoltaïques comprenant un assemblage de plusieurs cellules photovoltaïques reliées entre elles électriquement.

### Technique antérieure

On a déjà proposé des modules photovoltaïques comportant un assemblage de plusieurs cellules photovoltaïques reliées entre elles, par exemple dans la demande de brevet FR3051602A1.

Il serait toutefois souhaitable d'améliorer au moins en partie certains aspects des modules photovoltaïques connus.

### Résumé de l'invention

Un mode de réalisation pallie tout ou partie des inconvénients des modules photovoltaïques connus.

Un mode de réalisation prévoit un module photovoltaïque comprenant au moins un groupe de chapelets de cellules photovoltaïques s'étendant selon un plan principal, les cellules photovoltaïques d'un même chapelet étant électriquement reliées entre elles en série le long d'une première direction du plan principal, chaque groupe comportant au moins :
- un premier chapelet comprenant des premières cellules photovoltaïques parmi les cellules photovoltaïques, les premières cellules photovoltaïques présentant chacune une première largeur dans une deuxième direction du plan principal, perpendiculaire à la première direction ; et
- un deuxième chapelet comprenant des deuxièmes cellules photovoltaïques parmi les cellules photovoltaïques, les deuxièmes cellules photovoltaïques présentant chacune une deuxième largeur dans la deuxième direction, la deuxième largeur étant inférieure à la première largeur.

Selon un mode de réalisation, les premières cellules photovoltaïques correspondent à des premières portions de plaques photovoltaïques découpées au moins selon la deuxième direction et les deuxièmes cellules photovoltaïques correspondent à des deuxièmes portions des plaques photovoltaïques découpées selon la première direction et selon la deuxième direction.

Selon un mode de réalisation, les plaques photovoltaïques sont de forme sensiblement carrée ou rectangulaire dans le plan principal.

Selon un mode de réalisation, la deuxième largeur est sensiblement égale à la moitié de la première largeur.

Selon un mode de réalisation, un groupe parmi le au moins un groupe comporte en outre un troisième chapelet comprenant des troisièmes cellules photovoltaïques parmi les cellules photovoltaïques, les troisièmes cellules photovoltaïques présentant chacune une troisième largeur dans la deuxième direction, la troisième largeur étant différente de la première largeur e de la deuxième largeur.

Selon un mode de réalisation, la troisième largeur est inférieure ou égale à 20% de la première largeur.

Selon un mode de réalisation, le au moins un groupe comprend des chapelets électriquement reliés entre eux en parallèle, par exemple les premier et deuxième chapelets sont électriquement reliés entre eux en parallèle.

Selon un mode de réalisation, le au moins un groupe comprend des chapelets électriquement reliés entre eux en série, par exemple un troisième chapelet est électriquement relié en série avec les premier et deuxième chapelets.

Selon un mode de réalisation, les cellules photovoltaïques d'un même chapelet :
- sont alignées entre elles dans la première direction (X) ; et/ou
- ont toutes une même surface ; et/ou
- ont toutes une même largeur et une même longueur ; ou
- ont des largeurs et longueurs différentes, à surface égale.

Selon un mode de réalisation, les premières et les deuxièmes cellules photovoltaïques correspondent à des premières portions de plaques photovoltaïques découpées selon au moins une première ligne de découpe s'étendant dans la deuxième direction, les plaques photovoltaïques étant par exemple de forme sensiblement carrée ou rectangulaire dans le plan principal.

Selon un mode de réalisation, les deuxièmes cellules photovoltaïques correspondent à des deuxièmes portions de plaques photovoltaïques découpées selon au moins une première ligne de découpe s'étendant dans la deuxième direction et selon au moins une deuxième ligne de découpe s'étendant dans la première direction, les plaques photovoltaïques étant par exemple de forme sensiblement carrée ou rectangulaire dans le plan principal.

Selon un mode de réalisation, les troisièmes cellules photovoltaïques correspondent à des troisièmes portions de plaques photovoltaïques découpées selon au moins une première ligne de découpe s'étendant dans la deuxième direction et selon plusieurs deuxièmes lignes de découpe s'étendant dans la première direction.

Selon un mode de réalisation, chaque plaque photovoltaïque comprend des barres de connexion s'étendant dans la première direction, chaque deuxième ligne de découpe étant positionnée à mi-distance entre deux barres de connexion adjacentes et/ou à mi-distance entre un bord longitudinal s'étendant dans la première direction de la plaque photovoltaïque et une barre de connexion adjacente.

Selon un mode de réalisation, les premières portions ont des longueurs sensiblement égales dans la première direction.

Selon un mode de réalisation, les deuxièmes portions ont des largeurs sensiblement égales entre elles dans la deuxième direction.

Selon un mode de réalisation, les troisièmes portions ont des largeurs sensiblement égales entre elles dans la deuxième direction.

Selon un mode de réalisation, les cellules photovoltaïques comprennent chacune des barres de connexion s'étendant dans la première direction, et les cellules photovoltaïques d'un même chapelet sont reliées entre elles par des éléments conducteurs s'étendant dans la première direction, par exemple des rubans conducteurs en cuivre, les éléments conducteurs étant reliés aux barres de connexion des cellules photovoltaïques.

Selon un mode de réalisation, le module photovoltaïque comprend en outre un ensemble collecteur électrique configuré pour relier entre eux les éléments conducteurs des différents chapelets d'un même groupe de manière à faire circuler un courant dans les cellules photovoltaïques desdits chapelets entre une borne négative et une borne positive, l'ensemble collecteur électrique comprenant en outre un circuit de by-pass comprenant au moins une diode.

Selon un mode de réalisation, le au moins un groupe comprend plusieurs groupes électriquement reliés entre eux.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1A est une vue partielle en coupe représentant de façon schématique un exemple d'assemblage de cellules photovoltaïques ;
la figure 1B est une vue partielle en perspective de l'assemblage de la figure 1A ;
la figure 1C est une vue de dessus montrant un détail d'une des cellules photovoltaïques de l'assemblage de la figure 1A ;
la figure 2A est une vue de dessus représentant schématiquement une plaque photovoltaïque permettant d'obtenir par découpe deux cellules photovoltaïques du type des cellules photovoltaïques de l'assemblage de la figure 1A ;
la figure 2B est une vue de dessus représentant schématiquement un assemblage de plusieurs cellules photovoltaïques de la figure 2A, formant tout ou partie d'un chapelet de cellules ;
la figure 2C est une vue de dessus représentant schématiquement un groupe de deux chapelets assemblés en parallèle, similaires au chapelet de la figure 2B ;
la figure 3 est une vue de dessus représentant un module photovoltaïque selon un mode de réalisation ;
la figure 4A est une vue de dessus représentant un module photovoltaïque selon un exemple de réalisation ;
la figure 4B est une vue de dessus représentant un module photovoltaïque selon une variante de l'exemple de réalisation de la figure 4A ;
la figure 5 est une vue de dessus représentant un module photovoltaïque selon un autre exemple de réalisation ;
la figure 6 est une vue de dessus représentant un module photovoltaïque selon un autre exemple de réalisation ;
la figure 7 est une vue de dessus représentant un module photovoltaïque selon un autre exemple de réalisation ;
la figure 8 est une vue de dessus représentant un module photovoltaïque selon un autre exemple de réalisation ;
la figure 9 est une vue de dessus représentant un module photovoltaïque selon une variante de réalisation ; et
la figure 10 est une vue de dessus représentant un module photovoltaïque selon une autre variante de réalisation.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, la réalisation des cellules photovoltaïques constitutives des assemblages décrits n'a pas été détaillée, la réalisation de telles cellules photovoltaïques étant à la portée de l'homme du métier à partir des indications de la présente description.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures, étant entendu que, en pratique, les modules photovoltaïques décrits peuvent être orientés différemment.

Dans la description qui suit, lorsqu'il est fait référence à une cellule, il est fait référence sauf précision contraire à une cellule photovoltaïque, et lorsqu'il est fait référence à un module, il est fait référence sauf précision contraire à un module photovoltaïque. Dans la description qui suit, lorsqu'il est fait référence à un groupe, sauf précision contraire, il est fait référence à un groupe de chapelets, ou groupement de chapelets, un module photovoltaïque comprenant un ou plusieurs groupes de chapelets, non nécessairement tous identiques.

Dans la description qui suit, on appelle "longueur" d'une cellule photovoltaïque d'un assemblage de cellules la dimension de cette cellule dans la direction d'alignement des cellules de l'assemblage, qui correspond à la direction X repérée dans les figures, et "largeur" d'une cellule photovoltaïque la dimension de cette cellule dans une direction orthogonale à la direction d'alignement des cellules, correspondant à la direction Y repérée dans les figures. La même convention est prise pour l'assemblage des cellules. Dans les figures qui suivent, la longueur d'une cellule rectangulaire peut correspondre à la dimension de ses petits côtés et la largeur d'une cellule peut correspondre à la dimension de ses grands côtés.

Dans la description qui suit, on appelle "plan principal", le plan dans lequel s'étendent les cellules photovoltaïques d'un assemblage de cellules, correspondant au plan XY repéré dans les figures. Ce plan principal peut également correspondre au plan des plaques photovoltaïques.

Dans la description qui suit, les termes "longitudinal" et "longitudinalement" font référence à la direction de la longueur, qui correspond à la direction X repérée dans les figures, et les termes "transversal" et "transversalement" font référence à la direction de la largeur, qui correspond à la direction Y repérée dans les figures.

Sauf précision contraire, les expressions "environ", "approximativement", "sensiblement", et "de l'ordre de" signifient à 10 % ou à 10° près, de préférence à 5 % ou à 5° près.

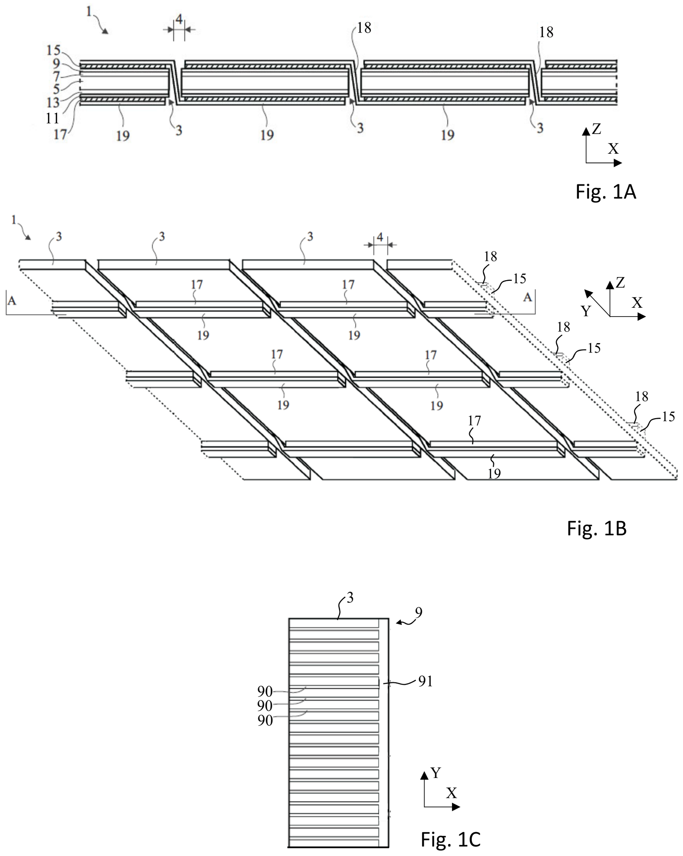

La figure 1A est une vue partielle en coupe représentant de façon schématique un exemple d'un assemblage 1 de cellules photovoltaïques 3. La figure 1B est une vue partielle en perspective de l'assemblage de la figure 1A. La figure 1C est une vue de dessus montrant un détail d'une des cellules photovoltaïques 3 de l'assemblage 1 de la figure 1A. La figure 1A est une coupe selon le plan A-A de la figure 1B. La figure 1B est une vue partielle en perspective de la face arrière de l'assemblage 1. La figure 1C est une vue partielle de dessus de la face avant de l'assemblage 1.

L'assemblage 1 peut être désigné par le terme de chapelet de cellules photovoltaïques, ou chapelet, ou encore par le terme de chaîne.

Les cellules 3 sont en forme de plaques rectangulaires et sont disposées côte à côte dans un même plan principal XY. Les cellules voisines ont leurs grands côtés en vis-à-vis séparés d'une distance 4. La dimension des grands côtés, ou largeur de l'assemblage 1, est typiquement comprise entre 125 mm et 210 mm, par exemple est de l'ordre de 156 mm, ou de l'ordre de 182 mm, ou encore de l'ordre de 210 mm. Les petits côtés des cellules 3 ont typiquement des dimensions comprises entre un vingt quatrième (1/24) de la largeur de l'assemblage et la largeur de l'assemblage, par exemple entre un tiers (1/3) de la largeur de l'assemblage et la largeur de l'assemblage.

Les cellules photovoltaïques 3 de l'assemblage 1 sont par exemple identiques, aux dispersions de fabrication près. Les cellules voisines ont leurs grands côtés sensiblement parallèles, et ont leurs petits côtés sensiblement alignés.

Chaque cellule 3 comprend une plaque semiconductrice 5, par exemple dopée de type P. La plaque semiconductrice 5 est par exemple en silicium. La plaque semiconductrice 5 peut être monocristalline ou multicristalline. L'épaisseur de la plaque semiconductrice 5 est par exemple comprise entre 100 et 300 µm.

Une couche 7 dopée de type N est positionnée sur la face avant de la plaque semiconductrice 5, c'est-à-dire sa face supérieure dans l'orientation de la vue de la figure 1A. La couche 7 s'étend par exemple sur une épaisseur comprise entre 0,05 et 0,1 µm. En vue de dessus, la couche 7 s'étend par exemple sur sensiblement toute la face avant de la plaque semiconductrice 5. La couche 7 peut être structurée du côté de sa face avant de façon à piéger la lumière du soleil et elle peut être recouverte d'une couche antireflet (non représentée).

Des structures collectrices 9 et 11, conductrices, sont situées respectivement sur, et en contact avec, les faces avant et arrière de chaque cellule 3.

La structure collectrice de face avant 9 et la structure collectrice de face arrière 11 sont chacune ajourées pour permettre à la lumière du soleil d'atteindre la face avant et la face arrière de la plaque semiconductrice 5.

A titre d'exemple non limitatif, comme représenté en figure 1C, la structure collectrice 9 en face avant est en forme de peigne dont les dents 90 forment avec la couche 7 des contacts électriques répartis, par exemple régulièrement répartis, sur la face avant de la couche 7. La structure collectrice 9 permet à la lumière du soleil d'accéder à la face avant de la plaque semiconductrice 5 revêtue de la couche 7 entre les dents 90 du peigne. Les dents 90 du peigne peuvent être reliées à une ou plusieurs bandes 91 qui s'étendent parallèlement au grand côté de la cellule 3 (dans la figure 1C, une seule bande 91 est représentée, bien qu'il puisse y en avoir plusieurs). Les dents 90 peuvent être réparties régulièrement et/ou peuvent s'étendre jusqu'au grand côté opposé à la bande 91. Les dents 90 ont par exemple une largeur comprise entre 2 et 5 µm et un pas compris entre 1 et 3 mm. Plus généralement, la structure collectrice 9 de face avant peut avoir toute autre forme adaptée à collecter de façon homogène les porteurs de charges générés dans la plaque semiconductrice 5 de la cellule 3.

La structure collectrice 9 peut être par exemple en argent ou en aluminium. La structure collectrice 9 peut aussi être une couche d'un matériau conducteur transparent, par exemple en oxyde d'étain et d'indium. La structure collectrice 9 peut avoir une épaisseur comprise entre 5 et 30 µm.

La structure collectrice 11 en face arrière est en contact avec la plaque semiconductrice 5, par exemple par l'intermédiaire d'une couche 13 plus fortement dopée de type P (couche P+) que la plaque semiconductrice 5. La structure collectrice 11 peut s'étendre de façon continue sur sensiblement toute la face arrière de la plaque semiconductrice 5. La couche 13 peut également s'étendre sur toute la face arrière de la plaque semiconductrice 5. A titre d'exemple, la structure collectrice 11 est une couche d'aluminium ou de bore, et la couche 13 peut résulter d'une diffusion de l'aluminium dans la plaque semiconductrice 5. En variante, la structure collectrice 11 est une couche constituée en partie d'argent et en partie d'aluminium.

Au besoin, si on souhaite que la face arrière des cellules photovoltaïques 3 recueille elle aussi de la lumière, par exemple par réflexion sur des surfaces disposées à l'arrière de l'assemblage 1, la structure collectrice 11 peut être une couche métallique ajourée, par exemple similaire à la structure collectrice 9, ou une couche d'un matériau conducteur transparent. Lorsque la structure collectrice 11 est ajourée ou transparente pour recueillir de la lumière en face arrière de la cellule 3, on parle alors de cellule photovoltaïque bifaciale.

Les structures collectrices 9 et 11 peuvent être munies de barres de connexion 15 et 17, typiquement en argent, continues ou discontinues, disposées respectivement sur les faces avant et arrière des cellules 3. Les barres de connexion 15, 17 de chaque cellule s'étendent généralement sur tout ou partie d'un grand côté à l'autre de la cellule dans le sens de la longueur de l'assemblage 1. Chaque cellule 3 peut ainsi être munie, sur chaque face avant et arrière, de barres de connexion 15, 17 réparties régulièrement, par exemple trois barres de connexion comme illustré en figure 1B, ou plus, par exemple dix barres de connexion. En variante, au lieu de barres de connexion, voire en complément, l'assemblage 1 peut comprendre des plots de connexion en faces arrière et avant des cellules, plus larges que les barres de connexion 15, 17 pour une meilleure soudure des rubans conducteurs 19 décrits plus après aux barres de connexion 15, 17. Ces plots de connexion peuvent être positionnés dans certains cas sur les bords des cellules 3.

Les cellules 3 de l'assemblage 1 sont électriquement reliées entre elles en série par des éléments conducteurs longilignes 19, qui sont des rubans conducteurs dans l'exemple représenté. Les rubans conducteurs 19 sont par exemple en cuivre, et sont par exemple recouverts d'une couche d'alliage d'étain, de plomb et/ou d'argent. La largeur des rubans conducteurs peut être comprise entre 0,2 et 2 mm. L'épaisseur des rubans conducteurs 19 peut être comprise entre 50 et 200 µm. En variante, au lieu de rubans conducteurs, il peut s'agir de fils conducteurs.

Les barres de connexion 15, 17 et les rubans conducteurs 19 s'étendent longitudinalement dans la direction de la longueur des cellules 3, c'est-à-dire la direction X repérée dans les figures 1A à 1C.

Chaque ruban conducteur 19 est relié d'une part à une barre de connexion 17 en face avant d'une cellule 3 et d'autre part à une barre de connexion 15 en face arrière d'une cellule 3 voisine. Chaque ruban conducteur 19 inclut une portion oblique 18 permettent de réaliser la liaison entre la barre de connexion 15 en face avant et la barre de connexion 17 en face arrière, cette portion oblique 18 passant entre deux cellules 3 voisines. Ainsi, chaque ruban conducteur 19 passe de la face avant d'une cellule 3 à la face arrière d'une cellule 3 voisine par la portion oblique 18.

Deux cellules voisines sont par exemple reliées par trois rubans conducteurs 19 parallèles, régulièrement répartis dans la direction de la largeur des cellules, c'est-à-dire la direction Y repérée dans les figures 1A à 1C.

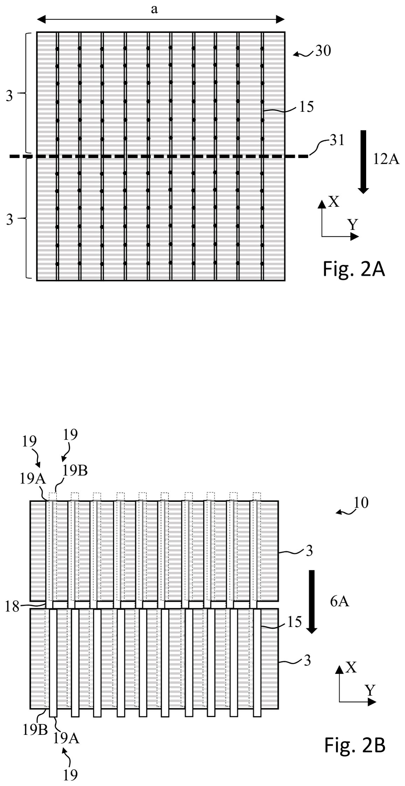

Le nombre de barres de connexion 15, 17 et de rubans conducteurs 19 reliant entre elles deux cellules 3 voisines peut toutefois être différent de trois, par exemple être égal à dix, comme décrit plus après en lien avec les figures 2A à 2C, ou tout autre nombre.

Aux extrémités, non représentées, de la répétition de cellules 3 les rubans conducteurs 19 peuvent être reliés à d'autres assemblages similaires connectés en série ou en parallèle avec l'assemblage 1 ou à des dispositifs électroniques tels que des convertisseurs.

En fonctionnement, lorsque les cellules photovoltaïques 3 sont exposées à la lumière du soleil, le courant produit par chaque cellule 3 est collecté en face avant par la structure collectrice 9, converge vers les barres de connexion 15 en face avant et chemine dans les rubans conducteurs 19 vers les barres de connexion 17 en face arrière de la cellule voisine. Le courant est réparti sur la face arrière de cette cellule voisine par la structure collectrice 11. Dans le cas d'une cellule bifaciale, le courant produit par chaque cellule peut également être collecté en face arrière par la structure collectrice 11.

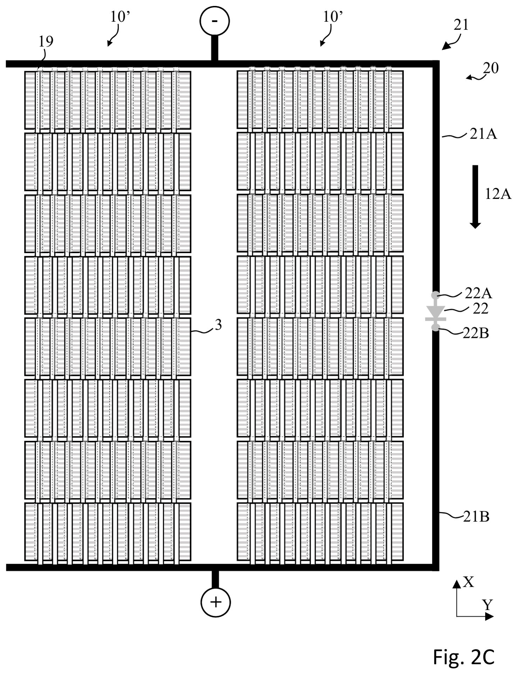

La figure 2A est une vue de dessus représentant schématiquement une plaque photovoltaïque 30 permettant d'obtenir par découpe deux cellules photovoltaïques 3 du type des cellules photovoltaïques de l'assemblage 1 de la figure 1A. Avec une plaque photovoltaïque 30, on peut former un assemblage de deux cellules photovoltaïques 3 correspondant chacune à une moitié de la plaque photovoltaïque 30. La figure 2B est une vue de dessus représentant schématiquement un assemblage 10 de plusieurs cellules photovoltaïques 3 de la figure 2A, formant tout ou partie d'un chapelet de cellules. La figure 2C est une vue de dessus représentant schématiquement un groupe 20 de deux chapelets 10' assemblés en parallèle, similaires au chapelet 10 de la figure 2B.

La plaque photovoltaïque 30 de la figure 2A présente une forme carrée. Les dimensions des côtés a de la plaque photovoltaïque 30 peuvent être comprises entre 125 mm et 210 mm, par exemple égales à environ 156 mm, ou à environ 182 mm, ou encore à environ 210 mm. La plaque photovoltaïque 30 correspond à deux cellules photovoltaïques 3 juxtaposées réunies par leurs grands côtés et destinées à être séparées au cours d'une étape de découpe selon une ou plusieurs lignes de découpe 31. On a représenté une seule ligne de découpe 31, bien qu'il puisse y avoir plusieurs lignes de découpe parallèles. Les faces avant des cellules photovoltaïques 3 sont orientées dans le même sens. La plaque photovoltaïque 30 inclut en particulier des structures collectrices en face avant et en face arrière, munie chacune de barres de connexion telles que les barres de connexion 15 et 17 décrites précédemment, qui peuvent être désignés "busbars" en anglais, ou barres omnibus en français. Dans la figure 2A, on n'a représenté que les barres de connexion 15 en face avant, les barres de connexion 17 en face arrière étant cachées.

La ligne de découpe 31 est perpendiculaire à la direction des barres de connexion 15, c'est-à-dire s'étend dans la direction de la largeur des cellules 3 (le long du grand côté de ces cellules), qui correspond à la direction Y repérée dans la figure 2A.

Cette découpe de la plaque photovoltaïque 30 en plusieurs cellules photovoltaïques 3 permet de réduire le courant maximal délivrable I_{mp-c} par chaque cellule photovoltaïque par rapport au courant maximal délivrable Iₘₚ₋ₚ de la plaque photovoltaïque, ce qui permet de réduire les pertes par effet Joule dans les cellules photovoltaïques. Par exemple, en découpant la plaque photovoltaïque en deux cellules photovoltaïques, le courant maximal délivrable I_{mp-c} de chaque cellule photovoltaïque est sensiblement égal à la moitié du courant maximal délivrable Iₘₚ₋ₚ de la plaque photovoltaïque, et les pertes par effet Joule peuvent ainsi être divisées par quatre. Dans l'exemple représenté, le courant Iₘₚ₋ₚ de la plaque photovoltaïque 30 est de 12A, et le courant I_{mp-c} de chacune des deux cellules photovoltaïques 3 est de 6A.

De plus, cette découpe permet que les rubans conducteurs 19 puissent passer entre les cellules photovoltaïques 3, et notamment puissent s'étendre en face avant et en face arrière des cellules photovoltaïques 3, comme décrit dans ce qui précède, ainsi que dans la description de la figure 2B qui suit.

L'assemblage de la figure 2B forme tout ou partie d'un chapelet 10 de cellules photovoltaïques 3 obtenues par la découpe d'une ou plusieurs plaques photovoltaïques 30 selon la ligne de découpe 31, comme décrit précédemment. Le chapelet 10 de la figure 2B est sensiblement similaire à l'assemblage 1 de la figure 1B, à ceci près que chaque cellule 3 comprend dix barres de connexion à chaque face, au lieu de trois, et qu'ainsi deux cellules 3 voisines sont reliées par dix rubans conducteurs 19, au lieu de trois. Les cellules photovoltaïques 3 du chapelet 10 sont reliées entre elles en série par les rubans conducteurs 19. On a représenté deux cellules 3 dans cette partie de chapelet, bien qu'il puisse y avoir un autre nombre de cellules reliées en série les unes avec les autres, par exemple huit comme représenté dans la figure 2C.

Les cellules photovoltaïques 3 du chapelet 10 sont identiques, aux dispersions de fabrication près.

De manière similaire à ce qui est représenté dans les figures 1A et 1B, chaque ruban conducteur 19 passe de la face avant d'une cellule 3 à la face arrière d'une cellule 3 voisine par une portion oblique 18. On a représenté en traits pleins des portions 19A des rubans conducteurs 19 qui sont en face avant des cellules 3, et en traits pointillés des portions 19B des rubans conducteurs 19 qui sont en face arrière des cellules 3. Pour chaque ruban conducteur 19, la portion 19A est reliée à la portion 19B par la portion oblique 18 qui passe entre deux cellules 3 adjacentes. Ainsi, chaque cellule 3 comprend des portions 19A pour relier les barres de connexion 15 en face avant et des portions 19B pour relier les barres de connexion en face arrière (non représentées dans les figures 2A et 2B). La largeur des rubans conducteurs 19 peut être égale à environ 0,4 mm. L'épaisseur des rubans conducteurs 19 peut varier entre 50 et 200 µm. On a représenté les rubans conducteurs 19 d'une même ligne longitudinale (direction X) en décalage dans la direction Y, bien que deux rubans conducteurs 19 soient généralement alignés dans cette ligne longitudinale.

Puisque les cellules 3 dans le chapelet 10 sont en série, le courant qui traverse le chapelet est sensiblement égal au courant qui traverse chaque cellule qui le compose. Ainsi, avec un courant maximal délivrable I_{mp-c} par cellule photovoltaïque 3 de 6A, le courant maximal qui peut traverser le chapelet 10 est également de 6A, et il est réparti dans chacun des rubans conducteurs 19 à environ 0,6A.

La figure 2C représente un groupe 20 de plusieurs chapelets 10', similaires au chapelet 10 de la figure 2B, à ceci près qu'on a représenté huit cellules 3 en série au lieu de deux cellules. Le groupe 20 comprend deux chapelets 10' reliés en parallèle. Le fait de relier deux chapelets en parallèle permet d'additionner les courants de ces chapelets, dans l'exemple représenté deux fois 6A, c'est-à-dire 12A, sans toutefois multiplier la tension par deux.

Les chapelets 10' du groupe 20 sont identiques entre eux, aux dispersions de fabrication près.

L'ensemble des rubans conducteurs 19 des chapelets 10' est relié à un ensemble collecteur électrique 21 comprenant deux collecteurs électriques, un collecteur 21A et un collecteur 21B, collectant l'ensemble des courants transportés par les rubans conducteurs 19. Ces collecteurs électriques 21A et 21B sont, dans la suite de la description, désignés rubans collecteurs. Les rubans collecteurs sont généralement nettement plus larges et plus épais que les rubans conducteurs 19 car ils doivent collecter un courant plus fort (par exemple jusqu'à dix fois) que les rubans conducteurs 19, et ce, afin de ne pas constituer une source de perte par effet Joule. Le ruban collecteur 21A constitue une borne négative (-) du groupe 20 qui est connectée à un plot de connexion 22A d'une diode dite de by-pass 22, et le ruban collecteur 21B constitue une borne positive (+) du groupe 20 qui est connectée à un autre plot de connexion 22B de la diode de by-pass 22. La diode de by-pass 22 vise à protéger les cellules 3 du groupe 20, notamment d'un risque de surchauffe, ou effet "hot spot" en anglais, effet point chaud.

Le groupe 20 peut former un module photovoltaïque. En variante, plusieurs groupes, du type de celui de la figure 2C, peuvent être reliés en série, voire en parallèle, pour former un module photovoltaïque.

Une limitation des assemblages décrits en relation avec les figures 1A à 1C et 2A à 2C concerne la question de l'agencement des cellules entre elles afin de constituer un ensemble compact permettant de couvrir une proportion maximale de la surface d'un module photovoltaïque. C'est le cas par exemple des modules photovoltaïques constituant des éléments de surface de l'enveloppe d'un bâtiment, comme c'est le cas de vitrages photovoltaïques dont les dimensions peuvent varier d'un étage à l'autre. C'est le cas aussi de modules photovoltaïques constituant des éléments de toiture, par exemple des tuiles ou des ardoises photovoltaïques dont le calepinage sur une portion de toiture donnée oblige à utiliser des dimensions de modules différentes. Augmenter la proportion de la surface d'un module photovoltaïque permet d'augmenter la puissance électrique de ce module photovoltaïque. La même situation est rencontrée lorsqu'on souhaite remplacer un module photovoltaïque sur une installation existante. C'est le cas du remplacement des modules photovoltaïques afin de pallier des défaillances ou des dégradations des modules photovoltaïques existant dans une installation, ou de satisfaire au besoin de "repowering" en anglais, c'est-à-dire au besoin d'un remplacement complet des modules photovoltaïques par de nouveaux modules photovoltaïques plus efficaces, c'est à dire plus producteurs d'énergie électrique pour la même surface, car généralement fabriqués suivant des technologies plus récentes. Un des objectifs de ce remplacement est qu'un système photovoltaïque existant puisse retrouver ses anciennes performances dans le cas des modules photovoltaïques dégradés, voire les augmenter dans le cas du repowering, et ce, en conservant les dimensions des structures mécaniques portant les modules photovoltaïques et en restant compatibles avec les autres éléments du système photovoltaïque, tels que les collecteurs électriques, les boîtiers de jonction, les onduleurs, les câbles, etc. Les dimensions des côtés des plaques photovoltaïques peuvent augmenter, par exemple de 156 mm pour d'anciennes plaques photovoltaïques à 182 mm pour des plaques photovoltaïques plus actuelles. Ainsi, de nombreux systèmes photovoltaïques construits avec des modules utilisant les anciennes technologies doivent être remplacés pour intégrer des cellules photovoltaïques plus larges. A titre d'exemple, la plupart des modules anciens ou nouveaux utilisent sur leur largeur six chapelets de cellules en parallèle : en passant de cellules de 156 mm de largeur à des cellules plus perforantes de 182 mm de largeur, la largeur des modules est donc augmentée de 6x26 mm soit d'au moins 156 mm. Ainsi, pour pouvoir utiliser des nouvelles cellules plus performantes, les supports mécaniques des modules doivent être complètement changés, ainsi que les connections et câbles entre les modules. Une autre condition à respecter pour ce remplacement est que le système photovoltaïque remplacé respecte des contraintes en termes de fonctionnement, par exemple de limites d'intensité et/ou de tension acceptables.

En particulier, les cellules photovoltaïques doivent être intégrées dans des groupes, ou des modules, ayant des dimensions données (largeur et longueur notamment, au millimètre près), tout en optimisant l'espace occupé dans ces groupes ou modules pour ne pas perdre en rendement, et les groupes ou modules formés par ces nouvelles cellules photovoltaïques doivent respecter une limite maximale d'intensité, par exemple moins de 12 Ampères (A) ou moins de 14 A, ainsi qu'une limite maximale de tension, par exemple de l'ordre de 40 Volts (V).

Les inventeurs proposent un module photovoltaïque permettant de répondre aux besoins d'amélioration décrits précédemment, et de pallier tout ou partie des inconvénients des modules photovoltaïques décrits précédemment.

Des modes de réalisation de modules photovoltaïques vont être décrits ci-après. Les modes de réalisation décrits sont non limitatifs et diverses variantes apparaîtront à la personne du métier à partir des indications de la présente description.

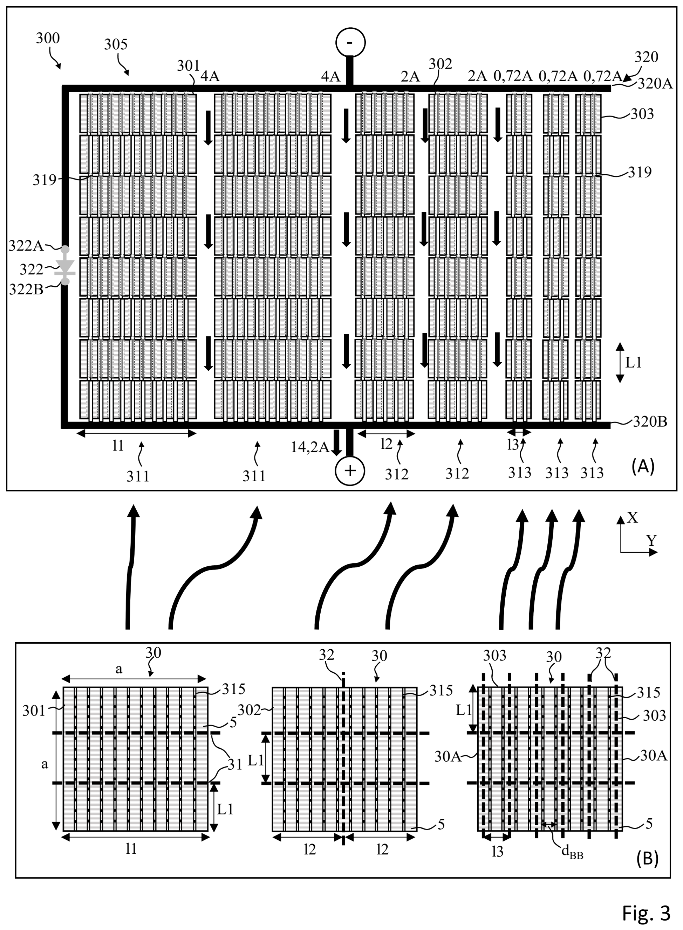

La figure 3 est une vue de dessus représentant un module photovoltaïque 300 selon un mode de réalisation. Le cadre (A) représente le module photovoltaïque 300. Le cadre (B) représente des plaques photovoltaïques 30 permettant d'obtenir les cellules photovoltaïques du module photovoltaïque représenté dans le cadre (A) de la figure 3.

Le module photovoltaïque 300 de la figure 3 comprend un groupe 305 de plusieurs chapelets (ou chaînes) 311, 312, 313 reliés en parallèle. Chaque chapelet 311, 312, 313 comprend plusieurs cellules photovoltaïques 301, 302, 303 reliées électriquement en série dans la direction de la longueur des cellules, c'est-à-dire la direction X repérée dans la figure 3. Les chapelets sont positionnés les uns à côté des autres dans la direction de la largeur des cellules, c'est-à-dire la direction Y repérée dans la figure 3. Les chapelets voisins sont séparés par une distance non nulle dans la direction Y.

Similairement à ce qui a été décrit précédemment, les cellules de chaque chapelet sont en forme de plaques rectangulaires et sont disposées côte à côte dans un même plan principal XY. Les cellules voisines d'un même chapelet ont leurs grands côtés en vis-à-vis séparés d'une distance non nulle dans la direction X, et leurs petits côtés alignés dans cette direction X. Les dimensions des cellules photovoltaïques d'un même chapelet sont sensiblement identiques, aux dispersions de fabrication près.

Dans l'exemple représenté, chaque chapelet 311, 312, 313 comprend huit cellules 301, 302, 303 en série, mais tout autre nombre de cellules dans un chapelet peut être envisagé. Dans l'exemple représenté, le module photovoltaïque 300 comprend sept chapelets reliés en parallèle, mais tout autre nombre de chapelets peut être envisagé.

Similairement à ce qui a été décrit dans ce qui précède, chaque cellule comprend des structures collectrices en face avant et en face arrière, munie chacune de barres de connexion continues ou discontinues, éventuellement munies de plots de connexion, qui peuvent être désignés "busbars" en anglais, ou barres omnibus en français. Dans le cadre (B) de la figure 3, on n'a représenté que les barres de connexion 315 en face avant, les barres de connexion en face arrière étant cachées. Les barres de connexion 315 sont par exemple en argent.

Similairement à ce qui a été décrit dans ce qui précède, les cellules voisines d'un même chapelet sont électriquement reliées entre elles en série par des rubans conducteurs 319, représentés dans le cadre (A) de la figure 3, qui sont par exemple en cuivre, éventuellement recouvert d'un alliage d'étain. La largeur des rubans conducteurs peut être comprise entre 0,2 et 2 mm, par exemple égale à environ 0,4 mm. L'épaisseur des rubans conducteurs peut être comprise entre 50 et 200 µm, par exemple égale à environ 200 µm. En variante, au lieu de rubans conducteurs, il peut s'agir de fils conducteurs. Les rubans conducteurs 319 peuvent passer entre deux cellules adjacentes d'un même chapelet, et notamment s'étendre successivement en face avant et en face arrière de deux cellules adjacentes d'un même chapelet, comme décrit en lien avec la figure 2B.

Les barres de connexion 315 et les rubans conducteurs 319 s'étendent sensiblement dans la direction X. Les barres de connexion 315 et les rubans conducteurs 319 d'un même chapelet sont de préférence régulièrement répartis dans la direction Y.

Le module photovoltaïque 300 de la figure 3 se distingue de l'assemblage 20 de la figure 2C principalement en ce qu'il comprend au moins deux chapelets différents, dans lesquels les largeurs des cellules photovoltaïques, c'est-à-dire les dimensions dans la direction Y, sont différentes, les longueurs des cellules de ces deux chapelets étant égales dans cet exemple.

Dans l'exemple représenté, le groupe 305 comprend :
- des chapelets 311 (premiers chapelets) comprenant des cellules 301 (premières cellules photovoltaïques) présentant chacune une largeur 11 (première largeur) dans la direction Y ; et
- des chapelets 312 (deuxièmes chapelets) comprenant des cellules 302 (deuxièmes cellules photovoltaïques) présentant chacune une largeur 12 (deuxième largeur) dans la direction Y, la largeur 12 étant inférieure à la largeur 11 ; et
- des chapelets 313 (troisièmes chapelets) comprenant des cellules 303 (troisièmes cellules photovoltaïques) présentant chacune une largeur 13 (troisième largeur) dans la direction Y, la largeur 13 étant inférieure à la largeur 11 et à la largeur 12.

Dans l'exemple représenté en figure 3, le module photovoltaïque 300 comprend deux chapelets 311, deux chapelets 312, et trois chapelets 313, mais d'autres nombres de chapelets 311, 312, 313 peuvent être envisagés.

Dans l'exemple représenté, la largeur 12 est sensiblement égale à la moitié de la largeur 11, et la largeur 13 est inférieure à 20% de la largeur 11. D'autres largeurs de cellules dans les différents chapelets peuvent être envisagés. Par exemple, comme décrit plus après, la largeur 11 est égale à environ 182 mm (correspondant au côté d'une plaque photovoltaïque carrée de 182 mm de côté non découpée dans la direction X de la longueur), la largeur 12 à environ 91 mm (correspondant au côté de la plaque photovoltaïque carrée de 182 mm de côté découpée en deux dans la direction X de la longueur) et la largeur 13 à inférieure à 36,4 mm.

Plus généralement, d'autres combinaisons de différents chapelets dans un groupe, ainsi que différents nombres et différentes largeurs des cellules dans ces différents chapelets peuvent être envisagées.

Comme représenté dans la figure 3, le nombre de rubans conducteurs 319 reliant les cellules 301, 302, 303 voisines d'un chapelet 311, 312, 313 dépend de la largeur des cellules de ce chapelet. Le nombre de rubans conducteurs 319 augmente avec la largeur des cellules. Ceci permet de répartir le transport du courant entre les différents rubans, et, par exemple, respecter une limite maximale de courant transporté dans chaque ruban conducteur. Cette limite maximale de courant dépend des caractéristiques du ruban conducteur, par exemple sa largeur, son épaisseur et/ou son matériau, et peut être par exemple comprise entre 0,4 et 0,6 Ampères (A).

Le nombre de rubans conducteurs 319 transportant le courant dans chaque chapelet doit de préférence rester proportionnel, ou en proportion légèrement supérieur, au courant transporté dans ce chapelet.

L'ensemble des rubans conducteurs 319 du groupe 305 de chapelets 311, 312, 313 est relié à un ensemble collecteur électrique 320 comprenant deux collecteurs électriques, un collecteur 320A et un collecteur 320B, collectant l'ensemble des courants transportés par les rubans conducteurs 319. Les collecteurs électriques 320A et 320B sont désignés rubans collecteurs. Les rubans collecteurs 320A, 320B sont généralement nettement plus larges et plus épais que les rubans conducteurs 319 car ils doivent collecter un courant plus fort (par exemple jusqu'à dix fois) que les rubans conducteurs 319, et ce, afin de ne pas constituer une source de perte par effet Joule.

Dans cet exemple, les deux rubans collecteurs 320A et 320B entourent le groupe 305 de chapelets. Le ruban collecteur 320A constitue une borne négative (-) du groupe 305 qui est connectée à un plot de connexion 322A d'une diode de by-pass 322. Le ruban collecteur 320B constitue une borne positive (+) du groupe 305 qui est connectée à un autre plot de connexion 322B de la diode de by-pass 322. La diode de by-pass 322 vise à protéger les cellules du groupe 305 de chapelets, notamment d'un risque de surchauffe, ou effet "hot spot" en anglais, effet point chaud. La diode de by-pass 322 est orientée dans le sens du courant, représenté par les flèches dans le cadre (A) de la figure 3.

Le groupe 305 de chapelets 311, 312, 313 peut former seul le module photovoltaïque 300, comme représenté dans la figure 3. En variante, plusieurs groupes, du type du groupe 305 de la figure 3, pourraient être reliés en série, voire en parallèle, pour former un module photovoltaïque plus grand.

Comme représenté dans le cadre (B) de la figure 3, pour obtenir les cellules photovoltaïques des différents chapelets, on peut partir de plusieurs plaques photovoltaïques 30 toutes similaires, et dans cet exemple similaires à la plaque photovoltaïque de la figure 2A. Dans l'exemple représenté, chaque plaque photovoltaïque 30 présente en vue de dessus une forme carrée dont le côté a est égal à environ 182 mm, et le courant maximal Iₘₚ₋ₚ est d'environ 12 A. Le côté a de la plaque photovoltaïque 30 est égal à la largeur 11, comme expliqué plus après. Les barres de connexion 315 de ces plaques photovoltaïques 30 sont de préférence réparties de manière régulière le long de la direction Y.

En variante, les plaques photovoltaïques 30 pourraient avoir une autre forme que la forme carrée, par exemple une forme rectangulaire, ou plus largement polygonale.

La figure 3(B) montre une série de découpes, selon des lignes de découpe 31 (premières lignes de découpe), des plaques photovoltaïques 30 dans la direction Y de la largeur, c'est-à-dire perpendiculairement aux barres de connexion 315. La figure 3(B) montre deux lignes de découpes 31 configurées pour que chaque plaque photovoltaïque 30 soit découpée en trois parts de longueurs L1 égales dans la direction X. Toutes les cellules photovoltaïques 301, 302, 303 ont ainsi une longueur L1, dans la direction X, égale à environ 60,7 mm. Ceci est une variante à la figure 2A qui montre une seule ligne de découpe 31 par plaque photovoltaïque dans la direction Y, sachant que, selon les modes de réalisation, la plaque photovoltaïque pourrait être découpée en deux (dans ce cas, la longueur des cellules serait de 91 mm) au lieu de trois, ou en toute autre fraction, régulièrement ou non régulièrement.

Le courant maximal délivrable dans une plaque photovoltaïque 30 découpée en trois est égal au courant Iₘₚ₋ₚ divisé par trois, soit environ 4 A pour une plaque photovoltaïque 30 de 12 A.

Les cellules 301 proviennent des découpes 31 uniquement, sans autre découpe et notamment sans découpe dans la direction X de la longueur. Les cellules 301 ont donc une largeur 11 (première largeur), dans la direction Y, égale au côté a de la plaque photovoltaïque, soit environ 182 mm.

Pour former chaque chapelet 311, on relie huit cellules 301 en série dans la direction X, notamment à l'aide des rubans conducteurs 319. Le courant transporté dans chaque chapelet 311 est égal au courant maximal des cellules 301, c'est-à-dire de la plaque photovoltaïque 30 découpée en trois, soit environ 4 A.

Pour obtenir les cellules 302 et les cellules 303, en plus des découpes 31, on découpe certaines plaques photovoltaïques 30 en plusieurs parts, de préférence égales, dans la direction X, c'est-à-dire parallèlement aux barres de connexion 315. Les découpes dans la direction X sont réalisées selon les lignes de découpes 32 (deuxièmes lignes de découpe) .

De préférence, chaque ligne de découpe 32 est localisée entre deux barres de connexion 315 adjacentes, à égale distance entre ces deux barres de connexion, par exemple pour conserver une répartition régulière des barres de connexion 315 dans les cellules 302, 303 formées. En d'autres termes, les découpes 32 sont de préférence réalisées de sorte que la largeur de semiconducteur (plaque semiconductrice 5 décrite en lien avec la figure 1A) de part et d'autre de chaque deuxième découpe 32 est sensiblement égale à la moitié de la distance entre deux barres de connexion 315 adjacentes.

Les cellules 302 sont formées à l'aide d'une seule découpe 32 réalisée au milieu des plaques photovoltaïques 30, c'est-à-dire centrée dans la direction Y. En d'autres termes, on redécoupe les plaques photovoltaïques 30 dans la direction X en deux parties de largeurs 12 égales. Les cellules 302 ont donc chacune une largeur 12 (deuxième largeur) égale à la moitié du côté a de la plaque photovoltaïque 30, soit environ 91 mm. Par cette nouvelle découpe, on divise en deux le courant maximal délivrable dans la plaque photovoltaïque 30 déjà découpée en trois, soit environ 2 A.

Pour former chaque chapelet 312, on relie huit cellules 302 en série dans la direction X, notamment à l'aide des rubans conducteurs 319. Le courant transporté dans chaque chapelet 312 est égal au courant maximal des cellules 302, c'est-à-dire de la plaque photovoltaïque 30 découpée en trois puis en deux, soit environ 2 A (4 A divisé par deux).

Les cellules 303 sont formées à l'aide de plusieurs découpes 32 des plaques photovoltaïques 30, les lignes de découpe 32 étant régulièrement réparties dans la direction Y. En d'autres termes, on redécoupe des plaques photovoltaïques 30 dans la direction X en plus de deux parties de largeurs 13 égales, dans l'exemple cinq parties de largeurs 13 égales. Les cellules 303 ont chacune une largeur 13 (troisième largeur) égale à environ 18% du côté de la plaque photovoltaïque, soit environ 32,7 mm, et non 20%. La largeur 13 est égale à 2 fois la distance d_{BB} entre deux barres de connexion 315 adjacentes. Le côté de la plaque a est égal à 11 fois d_{BB} et la largeur 13 des cellules 303 est égale à 2 d_{BB}, on obtient que la largeur 13 est égale à 2/11 du côté a, soit environ 18% et 32,7 mm pour un côté a égal 182 mm.

En outre, pour que les cellules 303 soient toutes sensiblement identiques, avec deux barres de connexion régulièrement réparties dans chaque cellule 303, une découpe 32 est réalisée à égale distance entre chaque bord longitudinal 30A (bord qui s'étend dans la direction X) de la plaque photovoltaïque 30 et la barre de connexion 315 la plus proche de ce bord longitudinal.

Il est à noter que, selon une variante, pour former les cellules 302, voire les cellules 301, on peut également prévoir de réaliser une découpe 32 à égale distance entre chaque bord longitudinal 30A de la plaque photovoltaïque 30 et la barre de connexion 315 la plus proche de ce bord longitudinal, similairement à ce qui est réalisé pour les cellules 303. On pourrait ainsi former des cellules 302 de largeur égale à environ 82 mm, au lieu de 91 mm. Similairement, on pourrait ainsi former des cellules 301 de largeur égale à environ 172 mm, au lieu de 182 mm.

Pour former chaque chapelet 313, on relie huit cellules 303 en série dans la direction X, notamment à l'aide des rubans conducteurs 319. Le courant transporté dans chaque chapelet 313 est égal au courant maximal des cellules 303, c'est à dire de la plaque photovoltaïque 30 découpée en trois puis réduite à 18%, soit environ 0,72 A (18% de 4 A).

Ainsi, dans la configuration de la figure 3, le groupe 305 des sept chapelets 311, 312, 313 de cellules 301, 302, 303 est configuré pour transporter au total environ 14,2 A. Il est possible d'ajuster l'intensité totale du groupe 315 de chapelets, par exemple de la réduire, par exemple en supprimant un ou plusieurs des chapelets 311, 312, 313, et/ou en adaptant les largeurs et/ou les longueurs des cellules 301, 302, 303 dans tout ou partie de ces chapelets.

Les modes de réalisation permettent ainsi une grande adaptabilité dans la réalisation de cellules photovoltaïques à partir de plaques photovoltaïques standards, de manière à former des modules photovoltaïques qui puissent s'adapter à différentes contraintes d'encombrement et/ou de fonctionnement.

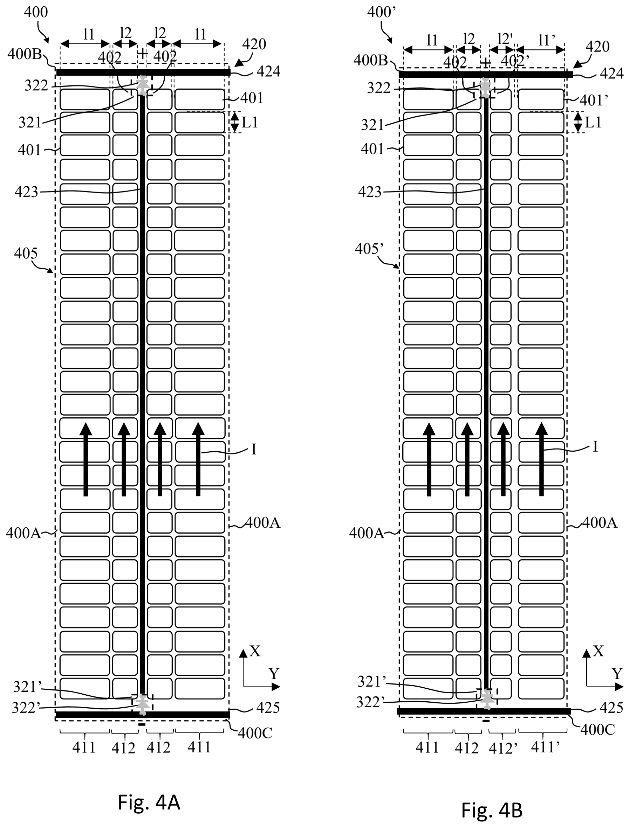

Les figures 4A à 10 qui suivent représentent plusieurs variantes de réalisation de chapelets, et de groupes de chapelets. Chaque groupe de chapelets peut former un module photovoltaïque, ou faire partie d'un module photovoltaïque plus grand. Un module photovoltaïque peut comprendre plusieurs groupes identiques de chapelets et/ou plusieurs groupes différents de chapelets. Pour alléger les figures 4A à 10, on ne représente ni les barres de connexions des cellules, ni les rubans conducteurs qui relient les cellules entre elles dans chaque chapelet. Les collecteurs électriques, ou rubans collecteurs, représentés dans les figures 4A à 10 et décrits dans ce qui suit sont reliés aux rubans conducteurs (non représentés) des chapelets. Les rubans collecteurs font partie d'un ensemble collecteur électrique. Par raccourci, un ruban collecteur peut être désigné ruban.

Dans les figures 4A à 10 qui suivent, on représente la circulation du courant I dans les chapelets par des flèches pleines épaisses, et on représente une borne négative (borne -) et une borne positive (borne +) entre lesquelles le courant circule. Chacune des bornes - et + est généralement connectée à un câble de sortie. Chaque groupe de chapelets comprend généralement au moins un circuit de by-pass avec une diode de by-pass, généralement comprise dans un boîtier de jonction qui comprend deux pôles. Chaque pôle d'un boîtier de jonction est relié à l'un des deux plots de connexion de la diode de by-pass qui est comprise dans ce boîtier de jonction, de sorte qu'en se connectant à un des pôles du boîtier de connexion, on se connecte à un des plots de connexion de la diode de by-pass.

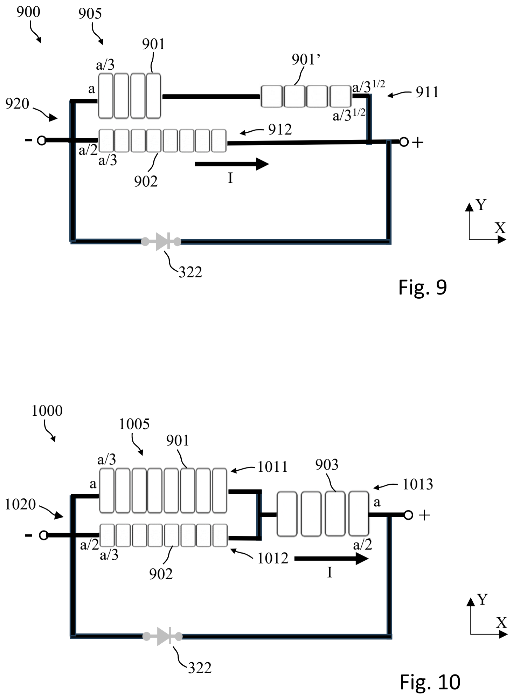

Les cellules photovoltaïques des figures 4A à 8 présentent toutes une même longueur L1 dans la direction X. Cette longueur L1 est par exemple égale à environ 60,7 mm, similairement aux cellules photovoltaïques de la figure 3. Ceci n'est pas limitatif, deux chapelets différents pouvant présenter des cellules de longueurs différentes, voire un chapelet pouvant présenter des cellules de longueurs et largeurs différentes, comme représenté par exemple dans les figures 9 et 10.

Les groupes de chapelets des figures 4A à 8 comprennent des chapelets 411, 411' comprenant des cellules photovoltaïques 401, 401' présentant chacune une largeur 11, l1' dans la direction Y et des chapelets 412, 412' comprenant des cellules photovoltaïques 402, 402' présentant chacune une largeur 12, l2' dans la direction Y, la largeur 12, l2' étant inférieure à la largeur 11, l1'. La largeur 12 peut être égale à environ la moitié de la largeur 11. A titre d'exemple, la largeur 11, l1' peut être égale à environ 182 mm, ou environ 172 mm, comme décrit plus avant en lien avec la figure 3. A titre d'exemple, la largeur 12, l2' peut être égale à environ 91 mm, ou environ 82 mm, comme décrit plus avant en lien avec la figure 3. Les chapelets 411, 411', 412, 412' comprennent chacun un nombre N de cellules photovoltaïques 401, 401', 402, 402' électriquement reliées entre elles en série dans la direction X, ce nombre N étant non limitatif, et pouvant varier par exemple entre 1 et 30, ou entre 4 et 30, ou encore entre 8 et 30, par exemple être égal à 4, 6, 8, 12, 22 ou 26.

La figure 4A est une vue de dessus représentant un module photovoltaïque 400 selon un exemple de réalisation.

Le module photovoltaïque 400 comprend un groupe 405 de P chapelets, où P est égal à quatre dans cet exemple : deux chapelets 411 et deux chapelets 412. Les chapelets sont reliés électriquement en parallèle. Les deux chapelets 411 sont positionnés le long des deux bords longitudinaux 400A du module 400, tandis que les deux chapelets 412 sont positionnés longitudinalement au centre du module 400, entre les deux chapelets 411.

Le module photovoltaïque 400 comprend en outre un ensemble collecteur électrique 420 comportant plusieurs rubans collecteurs : un ruban longitudinal 423 qui s'étend entre les deux chapelets 412, un ruban transversal 424 à un premier bord transversal 400B du module, et un ruban transversal 425 à un deuxième bord transversal 400C du module, opposé au premier bord transversal 400B. Un boîtier de jonction 321 relie le ruban transversal 424 à une première extrémité du ruban longitudinal 423. Un autre boîtier de jonction 321' relie le ruban transversal 425 à une deuxième extrémité, opposée à la première extrémité, du ruban longitudinal 423. Ainsi, le ruban longitudinal 423 s'étend entre le boitier de jonction 321 et le boitier de jonction 321'. Chaque boitier de jonction 321, 321' est muni d'une diode de by-pass 322, 322', similaire à la diode décrite en lien avec la figure 3. Chacun des deux pôles de chaque boîtier de jonction 321, 321' est relié à l'un des deux plots de connexion de la diode de by-pass 322, 322' qui est comprise dans ce boîtier de jonction.

Le ruban transversal 424 constitue une borne positive (+), correspondant au pôle supérieur du boîtier de jonction 321, et le ruban transversal 425 constitue une borne négative (-), correspondant au pôle inférieur du boîtier de jonction 321', le courant circulant dans les chapelets 411, 412 entre la borne négative et la borne positive. Le pôle supérieur du boitier de jonction 321, connecté au ruban transversal 424, peut être connecté à un câble qui constituera le câble de sortie positif (+) du module 400. Le pôle inférieur du boitier de jonction 321', connecté au ruban transversal 425, peut être connecté à un câble qui constituera le câble de sortie négatif (-) du module 400.

Les rubans transversaux 424, 425 visent à collecter le courant d'un chapelet à un autre.

Afin de ne conserver qu'une diode de by-pass au sein de ce module 400, on pourrait remplacer une des deux diodes de by-pass 322, 322' dans un des deux boîtiers de jonction 321, 321' par un connecteur conducteur court-circuitant les deux pôles de ce boîtier de jonction.

Dans cet exemple, on a représenté un ruban longitudinal 423 qui s'étend entre les deux chapelets 412, mais le ruban longitudinal 423 pourrait s'étendre entre deux autre chapelets, ou à droite ou à gauche du groupe 405 de chapelets. Plus généralement, la personne du métier pourra envisager tout autre ensemble collecteur électrique, avec une ou plusieurs boîtes de jonction chacune munie d'une diode de by-pass.

Un module avec un telle connexion électrique peut être désigné par module linéaire, ou linear en anglais (L).

Pour une plaque photovoltaïque de 182 mm de côté, similaire à la plaque photovoltaïque 30 de la figure 3, dont le courant maximal est Iₘₚ₋ₚ, une largeur 11 égale à 182 mm, une largeur 12 égale à 91 mm, et une longueur L1 de cellule égale à 60,7 mm, les inventeurs ont déterminé que le courant maximal I_{mp-c1} dans chaque cellule 401 et ainsi chaque chapelet 411 est égal à 0,333 Iₘₚ₋ₚ et que le courant maximal I_{mp-c2} dans chaque cellule 402 et ainsi chaque chapelet 412 est égal à 0,167 Iₘₚ₋ₚ. En additionnant les courants des quatre chapelets, on détermine le courant maximal du module 400, qui est dans ce cas égal au courant nominal Iₘₚ₋ₚ de la plaque photovoltaïque 30.

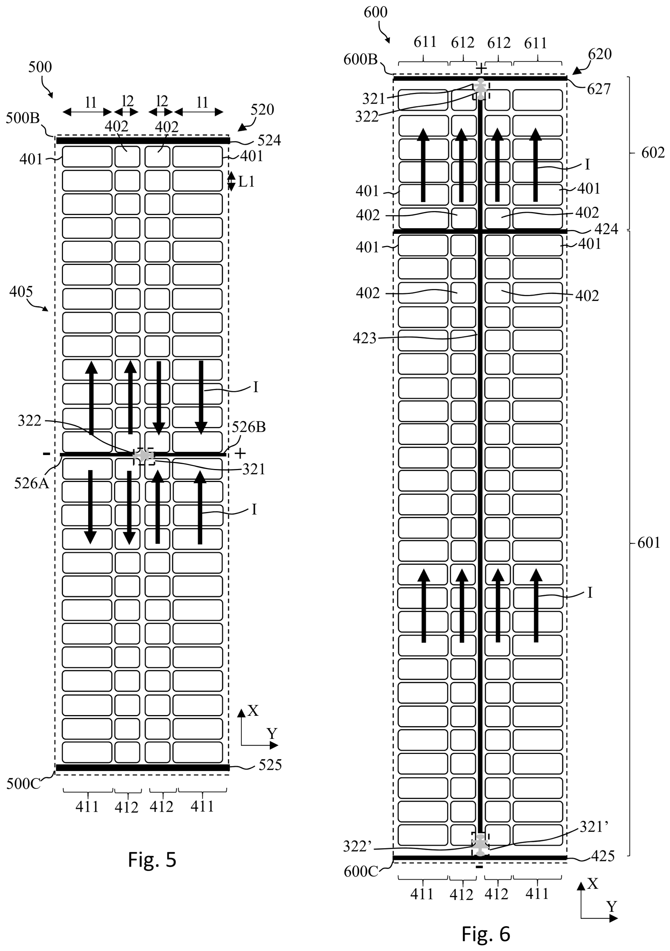

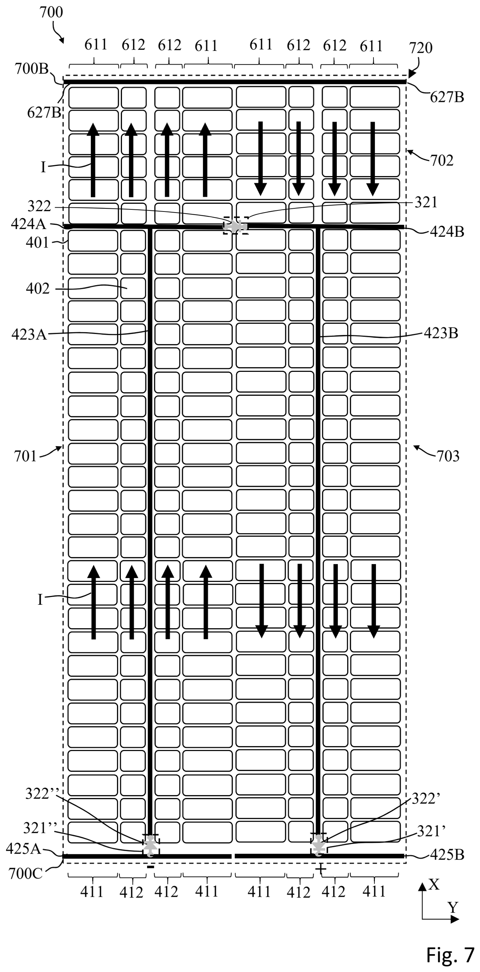

Le groupe 405 de chapelets de la figure 4A peut faire partie d'un module photovoltaïque plus grand, comme décrit plus après en lien avec la figure 6 ou la figure 7. Par exemple, un module photovoltaïque plus grand peut comprendre plusieurs groupes de chapelets similaires au groupe 405 de la figure 4A, par exemple plusieurs groupes de chapelets comprenant des nombres N de cellules différents entre les groupes.

La figure 4B est une vue de dessus représentant un module photovoltaïque 400' selon une variante de l'exemple de réalisation de la figure 4A.

Le module photovoltaïque 400' de la figure 4B se distingue de celui de la figure 4A en ce que les deux chapelets 411, 411' (le long des deux bords longitudinaux 400A du module 400') du groupe 405' ne sont pas identiques, le chapelet 411' comprenant des cellules 401' dont la largeur l1' est inférieure à la largeur 11 des cellules 401 du chapelet 411. Par exemple, la largeur l1' est égale à 172 mm pour le chapelet 411' et la largeur 11 est égale à 182 mm pour le chapelet 411. On peut ainsi réduire le courant maximal du module, puisque le courant maximal dans les cellules 401', et ainsi dans le chapelet 411', est de 0,315 Iₘₚ₋ₚ au lieu de 0,333 Iₘₚ₋ₚ. En additionnant ce courant avec les courants des trois autres chapelets 411, 412, 412' on détermine le courant maximal du module 400', qui est dans ce cas inférieur ou égal à 0,982 Iₘₚ₋ₚ, c'est-à-dire inférieur au courant nominal Iₘₚ₋ₚ de la plaque photovoltaïque 30.

En outre, les deux chapelets au centre du module 400' peuvent être différents. Par exemple, le chapelet 412' peut comprendre des cellules 402' dont la largeur l2' est inférieure à la largeur 12 des cellules 402 du chapelet 412, par exemple la largeur l2' est égale à 82 mm, et la largeur 12 est égale à 91 mm.

Dans les exemples de modules des figures 4A et 4B, on voit que le courant I circule dans un même sens dans tous les chapelets entre la borne positive (-) et la borne négative (+).

La figure 5 est une vue de dessus représentant un module photovoltaïque 500 selon un autre exemple de réalisation.

Le module photovoltaïque 500 de la figure 5 se distingue de celui de la figure 4A par la manière de relier les chapelets entre eux, le groupe 405 de chapelets étant par ailleurs similaire à celui de la figure 4A.

L'ensemble collecteur électrique 520 de la figure 5 comporte un ruban transversal 524 à un premier bord transversal 500B du module, un ruban transversal 525 à un deuxième bord transversal 500C du module, opposé au premier bord transversal 500B, et deux rubans transversaux centraux 526A, 526B isolés entre eux et positionnés entre le ruban transversal 524 et le ruban transversal 525, par exemple à mi-chemin entre le ruban transversal 524 et le ruban transversal 525. Le ruban transversal central 526A permet de relier les cellules 401, 402 des deux chapelets 411, 412 de gauche, tandis que le ruban transversal central 526B permet de relier les cellules 401, 402 des deux chapelets 411, 412 de droite. Les deux rubans transversaux centraux 526A, 526B permettent de mettre en parallèle les chapelets de la partie supérieure avec les chapelets de la partie inférieure. Les deux chapelets supérieurs de gauche sont reliés en série aux deux chapelets supérieurs de droite par le ruban transversal 524. Les deux chapelets inférieurs de gauche sont reliés en série aux deux chapelets inférieurs de droite par le ruban transversal 525. Le ruban transversal central 526A présente une borne négative (-) à son extrémité gauche et le ruban transversal central 526B présente une borne positive (+) à son extrémité droite.

Une boîte de jonction 321, munie d'une diode de by-pass 322, similaire à la diode décrite en lien avec la figure 3, est positionnée entre, et relie, les deux rubans transversaux centraux 526A et 526B, formant un circuit de by-pass.

La borne positive (+) peut être connectée à un câble qui constituera le câble de sortie positif (+) du module 500. La borne négative (-) peut être connectée à un câble qui constituera le câble de sortie négatif (-) du module 500.

Tout autre ensemble collecteur électrique peut être envisagé par la personne du métier.

On voit que le courant I circule dans des sens opposés selon les emplacement des chapelets. Dans les deux chapelets 411, 412 de gauche (côté borne négative (-)), le courant I circule depuis le ruban transversal central 526A vers le ruban transversal 524 et vers le ruban transversal 525, tandis que dans les deux chapelets 411, 412 de droite (côté borne positive (+)), le courant I circule depuis le ruban transversal 524 et depuis le ruban transversal 525 vers le ruban transversal central 526B.

Un module avec une telle connexion électrique peut être désigné par module papillon, ou Butterfly en anglais (B).

Ce type de configuration dit Butterfly permet de remplacer le ruban longitudinal 423 des figures 4A et 4B par les rubans transversaux 526A et 526B beaucoup plus courts. Ceci présente un premier avantage d'une économie de matériau conducteur et un deuxième avantage d'une occupation moindre de la surface du module non active du module, ce qui augmente l'efficacité, ou le rendement, de ce module.

Dans le cas d'un module Butterfly, les longueurs des câbles de sortie (+ et -) interconnectant des modules adjacents connectés suivant leur largeur, c'est-à-dire avec leurs grands côtés adjacents positionnés bord à bord, peuvent être très courts.

Dans le cas d'un module du type linéaire, ce sont les longueurs des câbles de sortie (+ et -) interconnectant des modules adjacents connectés suivant leur longueur, c'est-à-dire avec leurs petits côtés adjacents positionnés bord à bord, qui peuvent être très courts.

On a représenté 26 cellules 401, 401', 402, 402' par chapelet 411, 411', 412, 412' dans les figures 4A, 4B et 5, mais il pourrait y avoir tout autre nombre N de cellules. Comme indiqué précédemment, N peut varier entre 1 et 30, par exemple entre 4 et 30, ou entre 8 et 30, par exemple être égal à 4, 6, 8, 12, 22 ou 26.

La figure 6 est une vue de dessus représentant un module photovoltaïque 600 selon un autre exemple de réalisation.

Le module photovoltaïque 600 de la figure 6 se distingue de celui de la figure 4A en ce qu'il comporte un groupe 601 de chapelets, similaire au groupe 405 de chapelets de la figure 4A, et un autre groupe 602 de chapelets relié électriquement en série avec le groupe 601 dans la direction X. Les deux groupes 601, 602 sont alignés dans la direction X.

Le groupe 602 est similaire au groupe 601, à ceci près que les quatre chapelets 611, 612 du groupe 602 comportent chacun 6 cellules 401, 402 reliées en série dans la direction X, au lieu de 26 cellules pour les chapelets 411, 412 du groupe 601. Chaque chapelet 611, 612 du groupe 602 est aligné dans la direction X avec un chapelet 411, 412 de même largeur du groupe 601.

L'ensemble collecteur électrique 620 du module 600 comporte, en plus du ruban longitudinal 423, du ruban transversal 424, et du ruban transversal 425 de l'ensemble collecteur 420 décrit en lien avec la figure 4A, un ruban transversal 627 au premier bord transversal 600B du module 600 pour collecter le courant du groupe 602 (qui est entre le ruban transversal 424 et le ruban transversal 627). Le ruban transversal 424 est entre le groupe 601 et le groupe 602. Le ruban transversal 425 est au deuxième bord transversal 600C du module 600. Le ruban longitudinal 423 est relié par une de ses extrémités au ruban transversal 627 via un boîtier de jonction 321 muni d'une diode de by-pass 322. Le ruban longitudinal 423 est relié par l'autre de ses extrémités au ruban transversal 425 via un autre boîtier de jonction 321' muni d'une autre diode de by-pass 322'. Le ruban longitudinal 423 et le ruban transversal 424 sont connectés ensemble à leur point d'intersection. Chacun des deux pôles de chaque boîtier de jonction 321, 321' est relié à l'un des deux plots de connexion de la diode de by-pass 322, 322' qui est comprise dans ce boîtier de jonction. Ainsi, le ruban longitudinal 423 s'étend entre les boîtiers de jonction 321 et 321', et est relié à chacun des rubans transversaux 425 et 627 via une diode de by-pass 322, 322'. Le ruban transversal 627 constitue une borne positive (+), correspondant au pôle supérieur du boîtier de jonction 321, et le ruban transversal 425 constitue une borne négative (-), correspondant au pôle inférieur du boîtier de jonction 321'. Le courant circule dans les chapelets 411, 412, 611, 612 entre la borne négative (-) et la borne positive (+). Le pôle supérieur (+) du boitier de jonction 321 peut être connecté à un câble qui constituera le câble de sortie positif (+) du module 600. Le pôle inférieur (-) du boitier de jonction 321' peut être connecté à un câble qui constituera le câble de sortie négatif (-) du module 600.

On voit que le courant I circule dans un même sens dans tous les chapelets entre la borne négative (-) et la borne positive (+).

La figure 7 est une vue de dessus représentant un module photovoltaïque 700 selon un autre exemple de réalisation.

Le module photovoltaïque 700 de la figure 7 se distingue de celui de la figure 6 en ce qu'il comporte, en plus du groupe 701, qui est similaire au groupe 601 de la figure 6, un autre groupe 703 également similaire au groupe 601 de la figure 6, les groupes 701 et 703 étant alignés entre eux dans la direction Y, et encore un autre groupe 702 qui correspond à une juxtaposition dans la direction Y de deux groupes 602 de la figure 6 (sans bande longitudinale traversant ces groupes 602). Ces deux groupes 602 sont montés en série, de sorte que cela équivaut à doubler le nombre de cellules par chapelet, dans cet exemple à avoir douze cellules par chapelet au lieu de six. Le groupe 702 est positionné au-dessus des deux groupes 701, 703, et est aligné dans la direction X avec ces deux groupes 701, 703. Chaque chapelet 611, 612 du groupe 702 est aligné dans la direction X avec un chapelet 411, 412 de même largeur du groupe 701 ou du groupe 703.

L'ensemble collecteur électrique 720 du module 700 correspond pratiquement à une combinaison de deux ensembles collecteurs 620, avec les rubans longitudinaux 423 (423A et 423B), les rubans transversaux 424 (424A et 424B), les rubans transversaux 425 (425A et 425B), et les rubans transversaux 627 (627A et 627B) décrits en lien avec la figure 6, à ceci près que les rubans longitudinaux 423A et 423B ne se prolongent pas dans le groupe 702. Les deux rubans transversaux 425A et 425B sont isolés entre eux. Les deux rubans transversaux 627A et 627B sont reliés entre eux. Les deux rubans transversaux 424A et 424B sont reliés chacun à un boîtier de jonction 321 muni d'une diode de by-pass 322, le boîtier de jonction 321 étant entre les rubans transversaux 424A et 424B. Le ruban longitudinal 423A et le ruban transversal 425A sont reliés chacun à un autre boîtier de jonction 321'' muni d'une autre diode de by-pass 322'', le boîtier de jonction 321'' étant entre le ruban longitudinal 423A et le ruban transversal 425A. Le ruban longitudinal 423B et le ruban transversal 425B sont reliés chacun à un encore autre boîtier de jonction 321' muni d'une encore autre diode de by-pass 322', le boîtier de jonction 321' étant entre le ruban longitudinal 423B et le ruban transversal 425B. Le ruban longitudinal 423A et le ruban transversal 424A sont connectés ensemble à leur point d'intersection. Le ruban longitudinal 423B et le ruban transversal 424B sont connectés ensemble à leur point d'intersection.

Chacun des deux pôles de chaque boîtier de jonction 321, 321', 321'' est relié à l'un des deux plots de connexion de la diode de by-pass 322, 322', 322'' qui est comprise dans ce boîtier de jonction.

Le ruban transversal 425B constitue une borne positive (+), correspondant au pôle supérieur du boîtier de jonction 321', et le ruban transversal 425A constitue une borne négative (-), correspondant au pôle inférieur du boîtier de jonction 321''. Le pôle inférieur (+) du boitier de jonction 321' peut être connecté à un câble qui constituera le câble de sortie positif (+) du module 700. Le pôle inférieur (-) du boitier de jonction 321'' peut être connecté à un câble qui constituera le câble de sortie négatif (-) du module 700.

On voit que le courant I circule dans un sens qui part de la borne négative (-) dans tous les chapelets du groupe 701 et dans le sens opposé qui va vers la borne positive (+) dans tous les chapelets du groupe 703. Dans la partie gauche du groupe 702, le courant circule dans le même sens que dans le groupe 701, et dans la partie droite du groupe 702, le courant circule dans le même sens que dans le groupe 703.

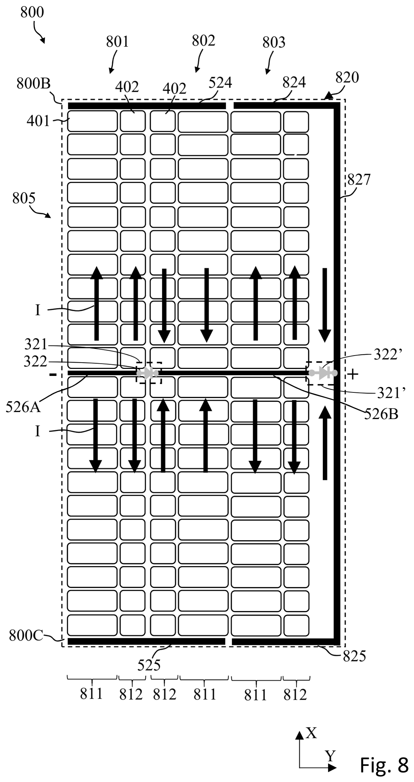

La figure 8 est une vue de dessus représentant un module photovoltaïque 800 selon un autre exemple de réalisation.

Le module photovoltaïque 800 de la figure 8 se distingue du module 500 de la figure 5 en ce que le groupe 805 de chapelets comporte six chapelets 811, 812, au lieu de quatre chapelets 411, 412 dans le groupe 505 de la figure 5. Ainsi, on a ajouté deux chapelets en série par rapport au groupe 505 de la figure 5. Chaque chapelet 811 comprend 33 cellules 401 reliées en série dans la direction X, similaires aux cellules 401 de la figure 4A. Chaque chapelet 812 comprend 33 cellules 402 reliées en série dans la direction X, similaires aux cellules 402 de la figure 4A. On a représenté 33 cellules 401, 402 par chapelet 811, 812, mais il pourrait y avoir tout autre nombre de cellules reliées en série dans chaque chapelet, par exemple 26 comme dans les autres exemples. Les chapelets sont regroupés en trois paires 801, 802, 803 de chapelets 811 et 812.

L'ensemble collecteur électrique 820 du module 800 se distingue de l'ensemble collecteur électrique 520 de la figure 5, en ce qu'il comprend en outre :
- un autre ruban transversal 824 au premier bord transversal 800B du module 800 pour les deux chapelets 811, 812 ajoutés, cet autre ruban transversal 824 étant isolé du ruban transversal 524 ;
- un autre ruban transversal 825 au deuxième bord transversal 800C du module 800 pour les deux chapelets 811, 812 ajoutés, cet autre ruban transversal 825 étant isolé du ruban transversal 525 ; et
- un ruban longitudinal 827 à droite des deux chapelets ajoutés, ce ruban longitudinal étant relié au ruban transversal 824 et au ruban transversal 825, mais étant isolé du ruban transversal central 526B.

En plus du boîtier de jonction 321 muni de la diode de by-pass 322, un autre boîtier de jonction 321' muni d'une autre diode de by-pass 322' est positionnée entre, et relie, le ruban transversal central 526B et le ruban longitudinal 827.

L'ensemble collecteur électrique 820 présente une borne positive (+) à l'extrémité droite du boîtier de jonction 321' sur le ruban longitudinal 827 et une borne négative (-) à l'extrémité gauche du ruban transversal 526A.

Cette configuration d'ensemble collecteur électrique permet que le courant I circule dans des sens opposés selon les paires de chapelets. Dans l'exemple représenté, le courant I circule depuis le ruban transversal central 526A vers le ruban transversal 524 et vers le ruban transversal 525 dans la paire 801 de chapelets la plus proche de la borne négative (-), depuis le ruban transversal 524 et le ruban transversal 525 vers le ruban transversal central 526B dans la paire 802 de chapelets centrale, et depuis le ruban transversal central 526B vers le ruban transversal 824 et vers le ruban transversal 825 dans la paire 803 de chapelets la plus proche de la borne positive (+), puis le courant retourne vers la borne positive (+) via le ruban longitudinal 827 relié aux rubans 824 et 825. En d'autres termes, le sens du courant alterne d'une paire de chapelets à une autre paire de chapelets adjacente.

On a représenté dans les figures 4A à 8 plusieurs exemples de groupes de chapelets, et plusieurs exemples de modules. La personne du métier pourra envisager d'autres modules, par exemple en faisant varier le nombre N de cellules dans les différents chapelets, les largeurs des cellules dans les différents chapelets, les longueurs des cellules dans les différents chapelets, le nombre P de chapelets dans chaque groupe, et/ou le nombre M de groupes dans le module. La personne du métier saura définir un ensemble collecteur électrique convenant au module.

En particulier, on a représenté, dans les figures 4A à 8, des exemples où chaque chapelet comprend des cellules de dimensions identiques. Ceci n'est pas limitatif et on peut envisager qu'au moins un chapelet comprenne des cellules de dimensions différentes, mais préférentiellement de surfaces sensiblement égales. Un exemple de cette variante est décrit ci-après en lien avec la figure 9.

En outre, on peut envisager d'avoir au moins deux chapelets reliés entre eux en série. Un exemple de cette variante est décrit ci-après en lien avec la figure 10.

Ces deux variantes peuvent être combinées entre elles et/ou avec tout exemple ou mode de réalisation décrit dans ce qui précède.

Dans les figures 9 et 10 qui suivent, on considère une plaque photovoltaïque de côté a utilisée pour former les cellules photovoltaïques des chapelets.

La figure 9 est une vue de dessus représentant un module photovoltaïque 900 selon une variante de réalisation.

Le module photovoltaïque 900 de la figure 9 comprend un groupe 905 de deux chapelets 911 et 912 reliés en parallèle. Le chapelet 911 comprend quatre cellules 901 de longueur a/3 et de largeur a, en série avec quatre cellules 901' de longueur a/√3 et de largeur a/√3. Ainsi, toutes les cellules du chapelet 911 ont la même surface, égale à a²/3. Le chapelet 912 comprend huit cellules 902 de longueur a/3 et de largeur a/2.

L'ensemble collecteur électrique 920 est configuré pour relier les chapelets 911, 912 entre eux en parallèle, et pour relier ce groupe 905 de chapelets à la borne négative (-) et à la borne positive (+). L'ensemble collecteur 920 comprend un circuit de by-pass comprenant une diode de by-pass 322.

La personne du métier pourra envisager toute autre combinaison de cellules de surface égale dans les chapelets, et adapter l'ensemble collecteur électrique pour relier électriquement les chapelets entre eux et aux bornes négative et positive.

Le module de la figure 9 peut correspondre à un groupe de chapelets d'un module photovoltaïque plus grand.

La figure 10 est une vue de dessus représentant un module photovoltaïque 1000 selon une variante de réalisation.

Le module photovoltaïque 1000 de la figure 10 comprend un groupe 1005 de trois chapelets : deux chapelets 1011 et 1012 reliés en parallèle, et un autre chapelet 1013 relié en série avec ces deux chapelets. Le chapelet 1011 comprend huit cellules 901 de longueur a/3 et de largeur a. Le chapelet 1012 comprend huit cellules 902 de longueur a/3 et de largeur a/2. Le chapelet 1013 comprend quatre cellules 903 de longueur a/2 et de largeur a.

L'ensemble collecteur électrique 1020 est configuré pour relier les chapelets 1011, 1012 entre eux en parallèle, le chapelet 1013 en série avec les chapelets 1011 et 1012, et pour relier ce groupe 1005 de chapelets à la borne négative (-) et à la borne positive (+). L'ensemble collecteur 1020 comprend un circuit de by-pass comprenant une diode de by-pass 322.

La personne du métier pourra envisager toute autre combinaison de cellules dans les chapelets, et adapter l'ensemble collecteur électrique pour relier électriquement les chapelets entre eux et aux bornes négative et positive.

Le module de la figure 10 peut correspondre à un groupe de chapelets d'un module photovoltaïque plus grand.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, les modes de réalisation décrits ne se limitent pas aux exemples de dimensions de cellules mentionnés dans la présente description, et aux exemples de nombre N de cellules, de nombre P de chapelets et de nombre M de groupes également mentionnés dans la présente description.

En outre, un module photovoltaïque peut comprendre, en plus d'un groupe de chapelets comprenant des largeurs de cellules différentes entre les chapelets, un groupe de chapelets dont les cellules ont les mêmes largeurs, voire un groupe d'un seul chapelet.

En outre, bien que les cellules photovoltaïques décrites comprennent chacune une plaque semiconductrice dopée de type P munie, en face avant, d'une couche dopée de type N, à titre de variante, chaque cellule peut comprendre une plaque semiconductrice dopée de type N munie, en face avant d'une couche dopée de type P.

Enfin, la mise en oeuvre pratique des modes de réalisation et variantes décrits est à la portée de la personne du métier à partir des indications fonctionnelles données ci-dessus.

## Revendications

1. Module photovoltaïque (300 ; 400 ; 400' ; 500 ; 600 ; 700 ; 800 ; 900 ; 1000) comprenant au moins un groupe (305 ; 405 ; 405'; 601, 602 ; 701, 702, 703 ; 805 ; 905 ; 1005) de chapelets de cellules photovoltaïques s'étendant selon un plan principal (XY), les cellules photovoltaïques d'un même chapelet étant électriquement reliées entre elles en série le long d'une première direction (X) du plan principal, chaque groupe comportant au moins :
- un premier chapelet (311 ; 411 ; 411' ; 811 ; 911 ; 1011) comprenant des premières cellules photovoltaïques (301 ; 401 ; 401' ; 901, 901') parmi les cellules photovoltaïques, les premières cellules photovoltaïques présentant chacune une première largeur (11 ; l1') dans une deuxième direction (Y) du plan principal, perpendiculaire à la première direction (X) ; et
- un deuxième chapelet (312 ; 412 ; 412' ; 812 ; 912 ; 1012) comprenant des deuxièmes cellules photovoltaïques (302 ; 402 ; 402' ; 902) parmi les cellules photovoltaïques, les deuxièmes cellules photovoltaïques présentant chacune une deuxième largeur (12 ; l2') dans la deuxième direction, la deuxième largeur étant inférieure à la première largeur ;
dans lequel :
- les premières cellules photovoltaïques correspondent à des premières portions de plaques photovoltaïques (30) découpées au moins selon la deuxième direction (Y) ; et
- les deuxièmes cellules photovoltaïques correspondent à des deuxièmes portions des plaques photovoltaïques (30) découpées selon la deuxième direction (Y) et selon la première direction (X).

2. Module photovoltaïque (300 ; 400 ; 500 ; 600 ; 700 ; 800 ; 900 ; 1000) selon la revendication 1, dans lequel la deuxième largeur (12) est sensiblement égale à la moitié de la première largeur (11).

3. Module photovoltaïque (300 ; 1000) selon la revendication 1 ou 2, dans lequel un groupe (305 ; 1005) parmi le au moins un groupe comporte en outre un troisième chapelet (313 ; 1013) comprenant des troisièmes cellules photovoltaïques (303 ; 903) parmi les cellules photovoltaïques, les troisièmes cellules photovoltaïques présentant chacune une troisième largeur (13) dans la deuxième direction (Y), la troisième largeur étant différente de la première largeur (11) et de la deuxième largeur (12).

4. Module photovoltaïque (300) selon la revendication 3, dans lequel la troisième largeur (13) est inférieure ou égale à 20% de la première largeur (11).

5. Module photovoltaïque (300 ; 400 ; 500 ; 600 ; 700 ; 800 ; 900 ; 1000) selon l'une quelconque des revendications 1 à 4, dans lequel le au moins un groupe (305 ; 405 ; 405'; 805 ; 905 ; 1005) comprend des chapelets électriquement reliés entre eux en parallèle, par exemple les premier et deuxième chapelets sont électriquement reliés entre eux en parallèle.

6. Module photovoltaïque (1000) selon l'une quelconque des revendications 1 à 5, dans lequel le au moins un groupe (1005) comprend des chapelets électriquement reliés entre eux en série, par exemple un troisième chapelet (1013) est électriquement relié en série avec les premier (1011) et deuxième (1012) chapelets.

7. Module photovoltaïque selon l'une quelconque des revendications 1 à 6, dans lequel les cellules photovoltaïques d'un même chapelet :
- sont alignées entre elles dans la première direction (X) ; et/ou
- ont toutes une même surface ; et/ou
- ont toutes une même largeur et une même longueur ; ou
- ont des largeurs et longueurs différentes, à surface égale.

8. Module photovoltaïque selon l'une quelconque des revendications 1 à 7, dans lequel les premières cellules photovoltaïques correspondent à des premières portions de plaques photovoltaïques (30) découpées selon au moins une première ligne de découpe (31) s'étendant dans la deuxième direction (Y), et les deuxièmes cellules photovoltaïques correspondent à des deuxièmes portions de plaques photovoltaïques (30) découpées selon la au moins une première ligne de découpe (31) et au moins une deuxième ligne de découpe (32) s'étendant dans la première direction (X).

9. Module photovoltaïque selon l'une quelconque des revendications 1 à 8, dans lequel les plaques photovoltaïques (30) sont de forme polygonale dans le plan principal, par exemple sensiblement carrée ou rectangulaire.

10. Module photovoltaïque selon l'une quelconque des revendications 1 à 9 dans sa dépendance avec la revendication 3 ou 4, dans lequel les troisièmes cellules photovoltaïques (313) correspondent à des troisièmes portions de plaques photovoltaïques (30) découpées selon au moins une première ligne de découpe (31) s'étendant dans la deuxième direction (Y) et selon plusieurs deuxièmes lignes de découpe (32) s'étendant dans la première direction.

11. Module photovoltaïque selon l'une quelconque des revendications 1 à 10, dans lequel chaque plaque photovoltaïque (30) comprend des barres de connexion (315) s'étendant dans la première direction (X), chaque deuxième ligne de découpe (32) étant positionnée à mi-distance entre deux barres de connexion adjacentes et/ou à mi-distance entre un bord longitudinal (30A), s'étendant dans la première direction, de la plaque photovoltaïque et une barre de connexion adjacente.

12. Module photovoltaïque selon l'une quelconque des revendications 1 à 11, dans lequel les premières portions ont des longueurs (L1) sensiblement égales entre elles dans la première direction (X), et/ou les deuxièmes portions ont des largeurs (12) sensiblement égales entre elles dans la deuxième direction (Y).

13. Module photovoltaïque selon l'une quelconque des revendications 1 à 12, dans lequel les cellules photovoltaïques comprennent chacune des barres de connexion (315) s'étendant dans la première direction (X), et les cellules photovoltaïques d'un même chapelet sont reliées entre elles par des éléments conducteurs (319) s'étendant dans la première direction, par exemple des rubans conducteurs en cuivre, les éléments conducteurs étant reliés aux barres de connexion des cellules photovoltaïques.

14. Module photovoltaïque selon la revendication 13, comprenant en outre un ensemble collecteur électrique (320 ; 420 ; 520 ; 620 ; 720 ; 820 ; 920 ; 1020) configuré pour relier entre eux les éléments conducteurs (319) des différents chapelets d'un même groupe de manière à faire circuler un courant dans les cellules photovoltaïques desdits chapelets entre une borne négative et une borne positive, l'ensemble collecteur électrique comprenant en outre un circuit de by-pass comprenant au moins une diode (322).

15. Module photovoltaïque (600 ; 700) selon l'une quelconque des revendications 1 à 14, dans lequel le au moins un groupe comprend plusieurs groupes (601, 602 ; 701, 702, 703) électriquement reliés entre eux.
